# EUROPEAN PATENT SPECIFICATION

(11) **EP 4 686 950 B1**
(45) Date of publication and mention of the grant of the patent: **27.05.2026**
(21) Application number: 24191691.5
(22) Date of filing: 30.07.2024
(51) Int. Cl.: G01R 27/32, G01R 31/28

(54) **RF FRONTEND AND VNA MEASUREMENT SYSTEM**
HF-FRONTEND- UND VNA-MESSSYSTEM
SYSTÈME DE MESURE DE FRONTAL RF ET DE VNA

(43) Date of publication of application: 04.02.2026
(73) Proprietor: Rohde & Schwarz GmbH & Co. KG, 81671 München (DE)
(72) Inventor: Burger, AnnaKatharina, 81671 München (DE); Harms, Julian, 81671 München (DE); Friesinger, Maximilian, 81671 München (DE); Huber, Florian, 81671 München (DE); Stumpf, Christopher, 81671 München (DE)
(74) Representative: Novagraaf Group

(56) References cited:
- CN-A- 104 316 795
- ES-T3- 2 354 891
- US-A- 5 191 294
- US-A1- 2007 159 182
- US-A1- 2020 103 458
- US-B1- 11 863 163
- US-B1- 6 714 898
- US-B1- 7 019 510
- US-B2- 11 233 585
- US-B2- 8 417 189

## Description

The present invention generally relates to a radio frequency, RF, frontend for a vector network analyzer, VNA, measurement system. The present invention further relates to a VNA measurement system.

Typically, VNA measurement systems comprise an RF frontend with a measurement signal path via which a measurement signal is received from a device under test, and a reference signal path via which a reference signal is received from a signal source.

Usually, these signal paths are optimized for specific types of measurements, such as the measurement of S-parameters of a device under test. An example of a VNA is described in document US7019510 B1.

However, if other types of measurements are to be performed by the VNA measurement system, the results may be not optimal, as the existing signal paths are optimized for said specific types of measurements.

Thus, the object of the present invention is to provide an RF frontend and a VNA measurement system that allow for an enhanced number of different measurement types.

According to the present invention, the problem is solved by a radio frequency, RF, frontend for a vector network analyzer, VNA, measurement system. The RF frontend comprises at least one port being connectable to a device under test. The RF frontend further comprises at least one measurement path that is connected to the at least one port. The RF frontend further comprises a first frontend portion and a second frontend portion. The first frontend portion comprises a first directional unit being connected to the at least one measurement path and being configured to couple an RF signal traveling towards the at least one port out of the at least one measurement path. The first frontend portion further comprises a second directional unit being connected to the at least one measurement path and being configured to couple an RF signal traveling away from the at least one port out of the at least one measurement path. The second frontend portion comprises a frequency combining unit and a switching stage. The switching stage comprises an input port, a common port, an output port, a first signal path, and a second signal path. The switching stage has a first switching state, wherein the switching stage is configured to forward a stimulus RF signal received by the input port to the common port via the first signal path in the first switching state. The switching stage has a second switching state, wherein the switching stage is configured to forward an RF signal received by the common port to the output port via the second signal path in the second switching state. The frequency combining unit is connected to the at least one measurement path. The frequency combining unit comprises a common port that is connected to the common port of the switching stage. The frequency combining unit is configured to couple the stimulus RF signal into the at least one measurement path. The frequency combining unit further is configured to couple an RF signal traveling away from the at least one port out of the at least one measurement path, such that the RF signal is forwarded to the common port of the frequency combining unit. The second frontend portion comprises a first amplifier that is arranged within the second signal path. The first amplifier is configured to amplify the RF signal received from the measurement path via the frequency combining structure, wherein the second frontend portion is configured to obtain an output signal based on the RF signal received from the measurement path via the frequency combining structure.

Therein and in the following, the term "module" is understood to describe suitable hardware, suitable software, or a combination of hardware and software that is configured to have a certain functionality.

The hardware may, inter alia, comprise a CPU, a GPU, an FPGA, an ASIC, or other types of electronic circuitry.

Further, the term "the second frontend portion is configured to obtain an output signal based on the RF signal" is understood to denote that the second frontend portion, particularly the second signal path, may process the RF signal, thereby obtaining the output signal. For example, the RF signal may be amplified, mixed with an LO signal, and/or converted to another frequency.

The RF frontend according to the present invention comprises the first frontend portion, which is generally configured to process a measurement signal, namely the RF signal coupled out of the measurement path by the second directional unit, and a reference signal, namely the RF signal coupled out of the measurement path by the first directional unit. For example, the first frontend portion may be used for performing S-parameter measurements.

The RF frontend according to the present invention is based on the idea to further add the second frontend portion, which provides two different functionalities associated with the two switching states.

In the first switching state of the switching stage, the second frontend portion forwards the stimulus RF signal to the measurement path, which may then be coupled out by the first directional unit of the first frontend portion. The stimulus RF signal may then be used as reference signal for performing measurements, particularly of S-parameters.

In the second switching state of the switching stage, the second frontend portion, more precisely the frequency combining unit, couples the RF signal traveling away from the at least one port, i.e. the measurement signal, out of the measurement path. The measurement signal may then be processed by the second signal path in an appropriate way, particularly by amplifying the measurement signal with the first amplifier.

The second signal path may be optimized in order to perform a certain type of measurement on the measurement signal.

In fact, the second signal path may be a dedicated signal path that is optimized for performing a certain type of measurement, namely a different type of measurement than performed by the first RF frontend portion.

For example, the second signal path may be optimized for performing noise figure measurements.

Accordingly, the first amplifier may be a low-noise amplifier, such that noise figure measurements can be performed on the output signal of the second frontend portion with reduced measurement times being necessary. In fact, as the first amplifier adds a particularly small amount of noise to the measurement signal, noise figure measurements can be performed in a particularly precise and time-efficient manner.

The frequency combining unit may, for example, be established as a diplexer or as a directional coupler, particularly as a diplexing forward coupler.

However, it is to be understood that the frequency combining unit may be established as any other suitable type of component or circuit being configured to perform the described functionality.

The first directional unit may, for example, be or comprise a directional coupler.

Likewise, the second directional unit may, for example, be or comprise a directional coupler.

The RF frontend may be a high-frequency frontend being configured to process frequencies above a predefined threshold. For example, the threshold may be 70 GHz.

Accordingly, the individual components of the RF frontend, particularly of the first frontend portion and of the second frontend portion, may be optimized for performing measurements on RF signals having a frequency above the predefined threshold.

Alternatively, the RF frontend may be a low-frequency frontend being configured to process frequencies below the predefined threshold.

Accordingly, the individual components of the RF frontend, particularly of the first frontend portion and of the second frontend portion, may be optimized for performing measurements on RF signals having a frequency below the predefined threshold.

Accordingly, the individual components of the RF frontend, particularly of the first frontend portion and of the second frontend portion, may be optimized for performing measurements on RF signals having a frequency above the predefined threshold.

According to an aspect of the present invention, the input port of the switching stage is connected or connectable to a signal source that is configured to generate the stimulus RF signal, particularly wherein the signal source is comprised in a VNA base system. Thus, the stimulus RF signal generated by the signal source is, in the first switching state of the switching stage, forwarded to the frequency combining unit via the first signal path. The stimulus RF signal is coupled into the measurement path by the frequency combining unit. The stimulus RF signal is then coupled out of the measurement path by the first directional unit of the first frontend portion, and can be used as a reference signal for performing measurements.

In an embodiment of the present invention, the output port of the switching stage is connected or connectable to a measurement module, particularly wherein the measurement module is comprised in a VNA base system. Accordingly, in the second switching state of the switching stage, the second frontend portion, more precisely the frequency combining unit, couples the RF signal traveling away from the at least one port, i.e. the measurement signal, out of the measurement path. The measurement signal may then be processed by the second signal path in an appropriate way, particularly by amplifying the measurement signal with the first amplifier, and the corresponding output signal is forwarded to the measurement module for further processing and/or analysis.

As already described above, the second signal path may be optimized for performing a certain type of measurements, such as noise figure measurements. Accordingly, in the second switching state of the switching stage, this certain type of measurements can be performed on the output signal of the switching stage, wherein the output signal corresponds to the measurement signal processed by the second signal path.

The second frontend portion may comprise a stimulus power amplifier being connected to the input port of the switching stage upstream of the input port. Alternatively or additionally, the second frontend portion may comprise an output amplifier being connected to the output port of the switching stage downstream of the output port.

Accordingly, a power level of the stimulus RF signal, which may be used as reference signal, can be adapted by the stimulus power amplifier. Alternatively or additionally, a power level of the output signal of the switching stage, which may be used as measurement signal for performing the certain type of measurement described above, e.g. a noise figure measurement, can be adapted by the output amplifier.

The output amplifier may be configured as a low-noise amplifier.

According to another aspect of the present disclosure, the second frontend portion comprises a mixing unit that is connected to the output port of the switching stage downstream of the output port. For example, the mixing unit may be configured to mix the output signal of the switching stage with a local oscillator signal and to filter the resulting signal appropriately, thereby converting the output signal of the switching stage to an intermediate frequency.

The mixing unit may be configured for or rather be optimized for performing the certain type of measurements described above, particularly for performing noise figure measurements.

Particularly, the mixing unit may be provided downstream of the output amplifier described above.

Particularly, the first frontend portion comprises a first pre-amplifier being connected to the first directional unit downstream of the first directional unit, and/or a second pre-amplifier being connected to the second directional unit downstream of the second directional unit. By means of the first pre-amplifier and the second pre-amplifier, power levels of the reference signal and of the measurement signal can be adapted, respectively.

In fact, the first pre-amplifier may be arranged between the first directional unit and the measurement module described above. Likewise, the second pre-amplifier may be arranged between the second directional unit and the measurement module described above.

According to a further embodiment of the present disclosure, the first frontend portion comprises a first mixing unit being connected to the first directional unit downstream of the first directional unit, and/or a second mixing unit being connected to the second directional unit downstream of the second directional unit.

The first mixing unit may be configured to mix the RF signal coupled out by the first directional unit, i.e. the reference signal, with a local oscillator signal and may filter the resulting signal appropriately, such that the reference signal is converted to an intermediate frequency.

Likewise, the second mixing unit may be configured to mix the RF signal coupled out by the second directional unit, i.e. the measurement signal, with the local oscillator signal and may filter the resulting signal appropriately, such that the measurement signal is converted to an intermediate frequency.

The first frontend portion and the second frontend portion may be arranged within a common housing. In other words, the common housing may enclose both the first frontend portion and the second frontend portion.

However, it is also conceivable that the first frontend portion is arranged in a first housing, while the second frontend portion is arranged in a second housing, wherein the first housing and the second housing are established separately from each other.

According to the present invention, the problem further is solved by a VNA measurement system. The VNA measurement system comprises an RF frontend according to any one of the variants described above. The VNA measurement system further comprises a VNA base system, wherein the VNA base system comprises a measurement module and a processing module. The processing module is configured to control the switching stage to selectively switch between the first switching state and the second switching state.

Regarding the further advantages and properties of the VNA measurement system, reference is made to the explanations given above with respect to the RF frontend, which also hold for the VNA measurement system and vice versa.

The VNA measurement system may further comprise a signal generator module, wherein the signal generator module is configured to generate the stimulus RF signal.

The signal generator module may be integrated into the VNA base system.

Alternatively, the signal generator module may be provided separately from the VNA base system.

According to an aspect of the present invention, the VNA base system is configured to receive a reference signal from the first directional unit, wherein the VNA base system further is configured to receive a measurement signal from the second directional unit, and wherein the processing module is configured to determine at least one measurement parameter based on the reference signal and based on the measurement signal, particularly wherein the at least one measurement parameter comprises at least one S-parameter.

However, it is to be understood that any other types of measurements may be performed by the measurement module.

Particularly, the measurement module may comprise at least one analog-to-digital converter (ADC) being configured to digitize the reference signal and/or the measurement signal.

Particularly, the measurement module may comprise a first ADC being connected to the first directional unit, wherein the first ADC is configured to digitize the reference signal.

The measurement module may further comprise a second ADC being connected to the second directional unit, wherein the second ADC is configured to digitize the measurement signal.

In an embodiment of the present invention, the VNA base system is configured to receive the output signal of the second frontend portion, wherein the measurement module is configured to determine at least one noise parameter based on the output signal. Accordingly, the measurement module may determine the at least one noise parameter based on the output signal being processed by the second signal path of the second frontend portion, wherein the second signal path may be optimized for performing the noise parameter measurement.

As already mentioned above, the first amplifier may be a low-noise amplifier, such that the at least one noise parameter can be determined with high precision and with reduced measurement time being necessary.

Particularly, the at least one noise parameter may be or comprise a noise figure.

The measurement module may comprise a third ADC being configured to digitize the output signal of the second frontend portion.

In a further embodiment of the present invention, the VNA measurement system comprises at least one further RF frontend, wherein the at least one further RF frontend comprises a measurement path, wherein the measurement path of the RF frontend and the measurement path of the at least one further RF frontend are connected with each other.

Therein, the at least one further RF frontend may be established analogously to the RF frontend described above.

The measurement path of the at least one further RF frontend may transition seamlessly into the measurement of the RF frontend.

In fact, the measurement path of the at least one further RF frontend and the measurement path of the RF frontend may be established by a single continuous signal line.

In a particular embodiment of the present invention, the RF frontend may be established as a high-frequency RF frontend, while the at least one further RF frontend may be established as a low-frequency RF frontend.

Accordingly, measurement signals having a frequency above the predefined threshold may be processed by the RF frontend, while measurement signals having a frequency below the predefined threshold may be processed by the at least one further RF frontend.

A further aspect of the present invention provides that the at least one further RF frontend comprises a first frontend portion and a second frontend portion, wherein the VNA measurement system further comprises a measurement switching module, wherein the measurement switching module is configured to selectively connect the first frontend portion of the RF frontend or the first frontend portion of the at least one further RF frontend to the VNA base system, and/or wherein the measurement switching module is configured to selectively connect the second frontend portion of the RF frontend or the second frontend portion of the at least one further RF frontend to the VNA base system. Accordingly, the particular frontend and the particular frontend portion processing the measurement signal and the reference signal can be selected by the measurement switching module.

For example, the RF frontend may be selected if a frequency of the reference signal and/or a frequency of the measurement signal is above the predefined threshold, e.g. above 70 GHz. The at least one further RF frontend may be selected if the frequency of the reference signal and/or the frequency of the measurement signal is below the predefined threshold.

For example, the measurement switching module may be controlled by the processing module described above, particularly automatically based on the frequency of the reference signal and/or based on the frequency of the measurement signal.

The RF frontend and the at least one further RF frontend may be arranged within a common housing. In other words, the common housing may enclose both the RF frontend and the at least one further RF frontend.

Alternatively, the RF frontend and the at least one further RF frontend may be arranged in separate housings.

The RF frontend and/or the at least one further RF frontend may be provided separately from the VNA base system, i.e. provided in a different housing.

Alternatively, the RF frontend and/or the at least one further RF frontend may be integrated into the VNA base system. In other words, the VNA measurement system may comprises a common housing, wherein the common housing encloses the VNA base system as well as the RF frontend and/or the at least one further RF frontend.

In an embodiment of the present disclosure, the VNA measurement system comprises a plurality of ports, wherein the VNA measurement system comprises an RF frontend according to any one of the variants described above per port. In other words, each port may be connected to a dedicated RF frontend. Thus, optimal processing of multiple measurement signals is ensured, particularly of measurement signals having a frequency above the predefined threshold.

Alternatively or additionally, the VNA measurement system may comprise at least one further RF frontend per port. In other words, each port may be connected to at least one dedicated further RF frontend. Thus, optimal processing of multiple measurement signals is ensured, particularly of measurement signals having a frequency below the predefined threshold.

The VNA base system may be connected to each of the frontends and/or to each of the further RF frontends, as described above with respect to the RF frontend and the at least one further RF frontend.

The foregoing aspects and many of the attendant advantages of the claimed subject matter will become more readily appreciated as the same become better understood by reference to the following detailed description, when taken in conjunction with the accompanying drawings, wherein:
- Figure 1 schematically shows a VNA measurement system according to a first variant of the present invention;
- Figure 2 shows a processing module of the VNA measurement system of Figure 1 in more detail; and
- Figure 3 schematically shows a VNA measurement system according to a second variant of the present invention.

The detailed description set forth below in connection with the appended drawings, where like numerals reference like elements, is intended as a description of various embodiments of the disclosed subject matter and is not intended to represent the only embodiments. Each embodiment described in this disclosure is provided merely as an example or illustration and should not be construed as preferred or advantageous over other embodiments. The illustrative examples provided herein are not intended to be exhaustive or to limit the claimed subject matter to the precise forms disclosed.

For the purposes of the present disclosure, the phrase "at least one of A, B, and C", for example, means (A), (B), (C), (A and B), (A and C), (B and C), or (A, B, and C), including all further possible permutations when more than three elements are listed. In other words, the term "at least one of A and B" generally means "A and/or B", namely "A" alone, "B" alone or "A and B".

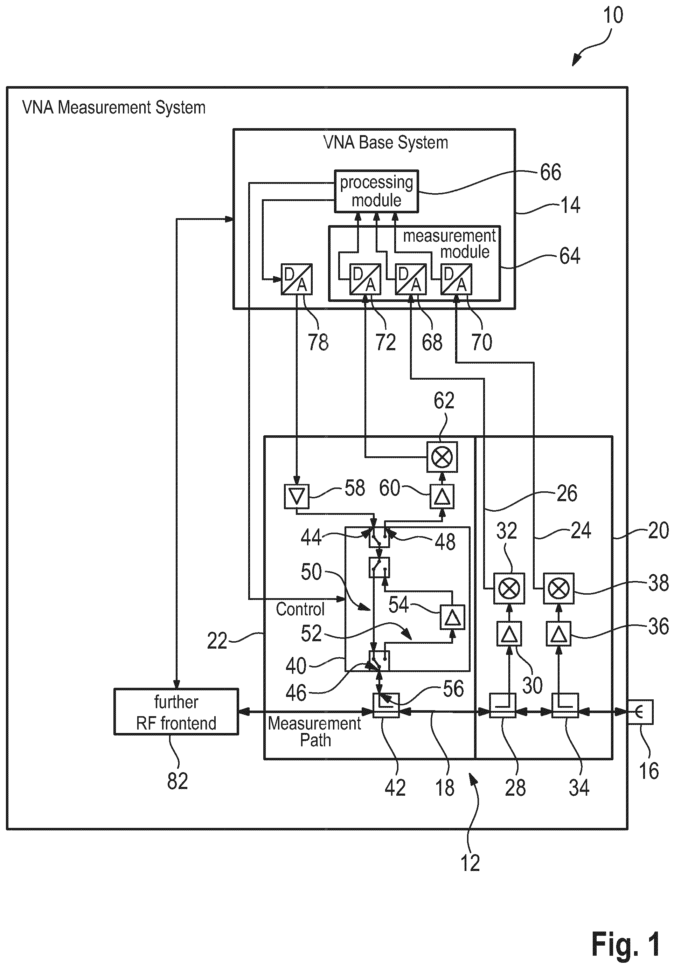

Figure 1 schematically shows a VNA measurement system 10 comprising an RF frontend 12 and a VNA base system 14.

In general, the VNA measurement system 10 is configured to perform measurements on an electronic device under test.

For example, the VNA measurement system 10 may be a vector network analyzer, wherein the RF frontend 12 and the VNA base system 14 may be integrated into the vector network analyzer.

Accordingly, the VNA base system 14 and the RF frontend 12 may be arranged within a common housing.

As another example, the VNA base system 14 may be a vector network analyzer, while the RF frontend 12 may be an external frontend for the vector network analyzer.

Accordingly, the RF frontend 12 and the VNA base system 14 may be provided in separate housings.

The VNA measurement system 10 comprises at least one port 16 that is connectable to the device under test.

In fact, the RF frontend 12 may comprise the at least one port 16.

However, it is to be understood that the VNA measurement system 10 may comprise a plurality of ports. In this case, the VNA measurement system 10 may comprise a plurality of RF frontends, wherein a dedicated RF frontend may be associated with each of the plurality of ports.

Without restriction of generality, the exemplary case of a single port 16 and a single RF frontend 12 is described hereinafter.

The RF frontend 12 comprises a measurement path 18 that is connected to the port 16.

In fact, the RF frontend 12 comprises a first frontend portion 20 and a second frontend portion 22, wherein the measurement path 18 extends through both the first frontend portion 20 and the second frontend portion 22.

The first frontend portion 20 comprises a measurement signal path 24, and a reference signal path 26.

The reference signal path 26 is connected to the measurement path 18 by a first directional unit 28, wherein the first directional unit 28 is configured to couple an RF signal traveling in the measurement path 18 towards the port 16 into the reference signal path 26, wherein the RF signal coupled into the reference signal path 26 is a reference signal.

Further, the first directional unit 28 is configured to forward the RF signal traveling in the measurement path 18 towards the port 16 to the port 16, wherein the RF signal forwarded to the port 16 may be applied to the device under test via the port.

For example, the first directional unit 28 may be established as a directional coupler.

The reference signal path 26 further comprises a first pre-amplifier 30 that is connected to the first directional unit 28 downstream of the first directional unit 28.

The first pre-amplifier is configured to amplify the reference signal described above.

The reference signal path 26 further comprises a first mixing unit 32 that is provided downstream of the first pre-amplifier 30.

The first mixing unit 32 may be configured to mix the reference signal with a local oscillator signal and to filter the resulting signal in order to select a desired intermediate frequency.

The measurement signal path 24 is connected to the measurement path 18 by a second directional unit 34, wherein the second directional unit 34 is configured to couple an RF signal traveling in the measurement path 18 away from the port 16 into the measurement signal path 24.

The RF signal coupled into the measurement signal path 24 is a measurement signal that may be received from the device under test via the port 16.

Further, the second directional unit 34 is configured to forward the RF signal traveling in the measurement path 18 away from the port 16 to the second frontend portion 22.

For example, the second directional unit 34 may be established as a directional coupler.

The measurement signal path 24 further comprises a second pre-amplifier 36 that is connected to the second directional unit 34 downstream of the second directional unit 34.

The second pre-amplifier 36 is configured to amplify the measurement signal.

The measurement signal path 24 further comprises a second mixing unit 38 that is provided downstream of the second pre-amplifier 36.

The second mixing unit 38 may be configured to mix the reference signal with a local oscillator signal and to filter the resulting signal in order to select a desired intermediate frequency.

The second frontend portion 22 comprises a switching stage 40 as well as a frequency combining unit 42 that connects the switching stage 40 to the measurement path 18.

Therein, the switching stage 40 comprises an input port 44, a common port 46, and an output port 48.

The switching stage 40 comprises a first signal path 50 that extends between the input port 44 and the common port 46.

The switching stage 40 further comprises a second signal path 52 that extends between the common port 46 and the output port 48.

The second signal path 52 comprises a first amplifier 54. For example, the first amplifier 54 may be a low-noise amplifier.

In fact, the switching stage 40 has a first switching state, wherein the switching stage 40 is configured to forward a stimulus RF signal received by the input port 44 to the common port 46 via the first signal path 50 in the first switching state.

The switching stage 40 has a second switching state, wherein the switching stage 40 is configured to forward an RF signal received by the common port 46 to the output port 48 via the second signal path 52 in the second switching state.

The frequency combining unit 42 comprises a common port 56 that is connected to the common port 46 of the switching stage 40.

In general, the frequency combining unit 42 is configured to couple an RF signal received from the switching stage 40 into the measurement path 18.

Further, the frequency combining unit 42 is configured to couple out an RF signal traveling in the measurement path 18 away from the port 16, such that the RF signal, namely the measurement signal received from the device under test via the port 16, is forwarded to the switching stage 40.

For example, the frequency combining unit 42 may be a diplexer or a directional coupler, particularly a diplexing forward coupler.

The second frontend portion 22 may further comprise a stimulus power amplifier 58 that is connected to the input port 44 of the switching stage 40 upstream of the input port 44.

The second frontend portion 22 may further comprise an output amplifier 60 that is connected to the output port 48 of the switching stage 40 downstream of the output port 48.

Downstream of the output amplifier 60, a mixing unit 62 may be provided.

The VNA base system 14 comprises a measurement module 64 and a processing module 66.

The measurement module 64 is connected to the measurement signal path 24, the reference signal path 26, as well as the second signal path 52, or more precisely to the output port 48 of the switching stage 40.

In fact, the measurement module 64 comprises a first ADC 68 that is connected to the reference signal path 26 and that is configured to digitize the reference signal.

Further, the measurement module 64 comprises a second ADC 70 that is connected to the measurement signal path 24 and that is configured to digitize the measurement signal.

Moreover, the measurement module 64 comprises a third ADC 72 that is connected to the output port 48 of the switching stage 40 and that is configured to digitize the output signal of the second frontend portion 22.

While not explicitly shown in Figure 1, the measurement module 64 may further be configured to filter, interpolate, and/or decimate the respective signals after digitization.

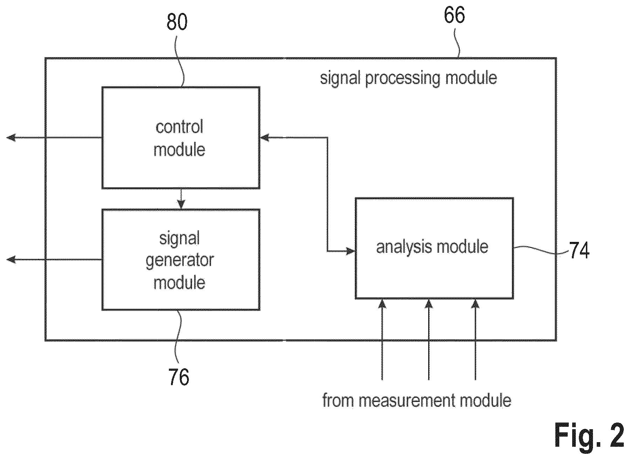

As is illustrated in Figure 2, the processing module 66 comprises an analysis module 74 that is connected to the measurement module 64, more precisely to the ADCs 68, 70, 72.

In general, the analysis module 74 is configured to analyze signals received from the measurement module 64, as will be described in more detail below.

The processing module 66 further comprises a signal generator module 76 that is configured to generate a stimulus RF signal, particularly a digital stimulus RF signal.

As is shown in Figure 1, the VNA base system 14 may comprise a digital-to-analog converter (DAC) 78 that is connected to the signal generator module 76 and that is configured to convert the digital stimulus RF signal into an analog stimulus RF signal.

It is to be understood that while the signal generator module 76 is shown to be integrated into the processing module 66 and thus into the VNA base system 14 in Figures 1 and 2, the signal generator module 76 may also be established separately from the VNA base system 14, particularly in a different housing.

Referring back to Figure 2, the processing module 66 further comprises a control module 80.

The control module 80 is connected to the switching stage 40, wherein the control module 80 is configured to control the switching stage 40 to selectively switch between the first switching state and the second switching state.

The control module 80 may further be configured to set operational parameters of the signal generator module 76 and/or of the analysis module 74 for performing certain types of measurements.

The VNA measurement system 10, or more precisely the VNA base system 14 in cooperation with the RF frontend 12, is configured to perform measurements on the device under test as is described hereinafter.

In a first measurement mode, the control module 80 controls the switching stage 40 to enter the first switching state.

In this first measurement mode, the stimulus RF signal is generated by the signal generator module 76, and the stimulus RF signal is forwarded to the frequency combining unit 42 via the first signal path 50 of the switching stage 40.

The stimulus RF signal is coupled into the measurement path 18 by the frequency combining unit 42 and is applied to the device under test via the port 16.

Moreover, the stimulus RF signal is coupled out of the measurement path 18 by the first directional unit 28, thereby obtaining the reference signal for performing the measurements.

A measurement signal is received from the device and the test by the port 16, and the measurement signal is coupled out of the measurement path 18 by the second directional unit 34.

The measurement signal may correspond to the stimulus RF signal being reflected at the device under test or to the stimulus RF signal that has been processed by the device under test.

The reference signal and the measurement signal are forwarded to the measurement module by the reference signal path 26 and the measurement signal path 24, respectively.

There reference signal in the measurement signal are digitized by the measurement module 64, and the resulting digitized reference signal and the digitized measurement signal are forwarded to the analysis module 74.

The analysis module 74 determines at least one measurement parameter based on the digitized reference signal and based on the digitized measurement signal.

For example, the at least one measurement parameter comprises at least one scattering parameter, particularly at least one S-parameter.

However, it is to be understood that any other type of measurement may be performed.

In a second measurement mode, the control module 80 controls the switching stage 40 to enter the second switching state.

In the second measurement mode, a measurement signal is received from the device under test via the port 16.

The measurement signal is coupled out of the measurement path 18 by the frequency combining unit 42, and the measurement signal is processed by the second signal path 52 of the switching stage 40.

In the exemplary embodiment shown in Figure 1, the measurement signal is amplified by the first amplifier 54, which may be established as a low-noise amplifier.

The measurement signal may then be further amplified by the output amplifier 60, processed by the mixing unit 62, and the resulting measurement signal is forwarded to and digitized by the measurement module 64.

The digitized measurement signal is forwarded to the analysis module 74.

In general, the analysis module 74 performs a different type of measurement on the measurement signal in the second measurement mode compared to the first measurement mode.

For example, in the second measurement mode, the analysis module 74 may be configured to determine at least one noise parameter based on the measurement signal processed by the second signal path 52 of the switching stage 40.

In a particular example, the at least one noise parameter may comprise a noise figure.

The RF frontend 12 described above may only be configured to or rather be optimized for processing RF signals in a certain frequency range.

For example, the RF frontend 12 may be a high-frequency frontend being configured to process frequencies above a predefined threshold, such as 70 GHz.

It is to be understood that the threshold may be at any other suitable frequency.

Referring back to Figure 1, the VNA measurement system 10 may comprise at least one further RF frontend 82.

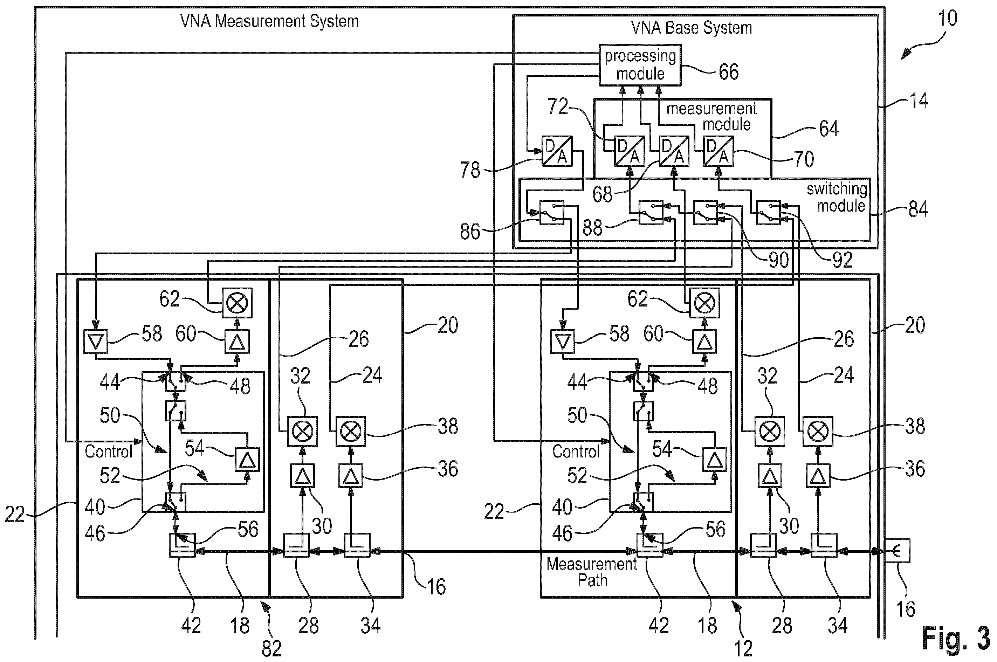

The further RF frontend 82 is described in more detail hereinafter with reference to Figure 3, which shows a further exemplary embodiment of the VNA measurement system 10.

In general, the at least one further RF frontend 82 may be established analogously to the RF frontend 12, but may be configured for processing signals in a different frequency range, such as in a frequency range below the predefined threshold described above.

Accordingly, while the same reference numerals are used for the individual components of the further RF frontend 82 and of the RF frontend 12 in Figure 3, it is to be understood that the individual components of the further RF frontend 82 and of the RF frontend 12 may be configured for different frequency ranges.

In fact, the components of the RF frontend 12 may be configured for frequencies above the predefined threshold, while the components of the further RF frontend 82 may be configured for frequencies below the predefined threshold.

Accordingly, the same measurements of the at least one measurement parameter and of the at least one noise parameter described above can be performed by the further RF frontend 82, but with the frequency of the reference signal and of the measurement signal being below the predefined threshold.

The measurement path 18 may extend trough both the RF frontend 12 and the further RF frontend 82.

In other words, the measurement paths 18 of the RF frontend 12 and of the further RF frontend 82 may be established as a single continuous signal line.

The RF frontend 12 and the further RF frontend 82 may be arranged within a common housing. In other words, the common housing may enclose both the RF frontend 12 and the further RF frontend 82.

Alternatively, the RF frontend 12 and the further RF frontend 82 may be arranged in separate housings.

The RF frontend 12 and/or the further RF frontend 82 may be provided separately from the VNA base system 14, e.g. provided in a different housing.

Alternatively, the RF frontend 12 and/or the further RF frontend 82 may be integrated into the VNA base system 14.

In the exemplary embodiment shown in Figure 3, the VNA measurement system 10 further comprises a measurement switching module 84 that is interconnected between the RF frontends 12, 82 and the measurement module 64.

In general, the measurement switching module 84 is configured to selectively connect the RF frontend 12 or the further RF frontend 82 to the measurement module 64.

Further, the measurement switching module 84 may be configured to selectively connect the RF frontend 12 or the further RF frontend 82 to the processing module 66.

In fact, the control module 80 may be configured to control the measurement switching module 84 to selectively connect the RF frontend 12 or the further RF frontend 82 to the measurement module 64 and to the processing module 66.

Therein, the RF frontend 12 may be selected if the frequency of the reference signal and/or the frequency of the measurement signal is above the predefined threshold, e.g. above 70 GHz. The further RF frontend 82 may be selected if the frequency of the reference signal and/or the frequency of the measurement signal is below the predefined threshold.

In fact, the measurement switching module 84 may comprise a first switching unit 86 that is configured to selectively connect the input port 44 of the RF frontend 12 or the input port 44 of the further RF frontend 82 to the signal generator module 76.

The measurement switching module 84 may further comprise a second switching unit 88 that is configured to selectively connect the output port 48 of the RF frontend 12 or the output port 48 of the further RF frontend 82 to the measurement module 64, particularly to the third ADC 72.

The measurement switching module 84 may further comprise a third switching unit 90 that is configured to selectively connect the reference signal path 26 of the RF frontend 12 or the reference signal path 26 of the further RF frontend 82 to the measurement module 64, particularly to the first ADC 68.

The measurement switching module 84 may further comprise a fourth switching unit 92 that is configured to selectively connect the measurement signal path 24 of the RF frontend 12 or the measurement signal path 24 of the further RF frontend 82 to the measurement module 64, particularly to the second ADC 70.

Certain embodiments disclosed herein, particularly the respective module(s) and/or unit(s), utilize circuitry (e.g., one or more circuits) in order to implement standards, protocols, methodologies or technologies disclosed herein, operably couple two or more components, generate information, process information, analyze information, generate signals, encode/decode signals, convert signals, transmit and/or receive signals, control other devices, etc. Circuitry of any type can be used.

In an embodiment, circuitry includes, among other things, one or more computing devices such as a processor (e.g., a microprocessor), a central processing unit (CPU), a digital signal processor (DSP), an application-specific integrated circuit (ASIC), a field-programmable gate array (FPGA), a system on a chip (SoC), or the like, or any combinations thereof, and can include discrete digital or analog circuit elements or electronics, or combinations thereof. In an embodiment, circuitry includes hardware circuit implementations (e.g., implementations in analog circuitry, implementations in digital circuitry, and the like, and combinations thereof).

In an embodiment, circuitry includes combinations of circuits and computer program products having software or firmware instructions stored on one or more computer readable memories that work together to cause a device to perform one or more protocols, methodologies or technologies described herein. In an embodiment, circuitry includes circuits, such as, for example, microprocessors or portions of microprocessor, that require software, firmware, and the like for operation. In an embodiment, circuitry includes one or more processors or portions thereof and accompanying software, firmware, hardware, and the like.

The present application may reference quantities and numbers. Unless specifically stated, such quantities and numbers are not to be considered restrictive, but exemplary of the possible quantities or numbers associated with the present application. Also in this regard, the present application may use the term "plurality" to reference a quantity or number. In this regard, the term "plurality" is meant to be any number that is more than one, for example, two, three, four, five, etc. The terms "about", "approximately", "near" etc., mean plus or minus 5% of the stated value.

## Claims

1. A radio frequency, RF, frontend for a vector network analyzer, VNA, measurement system (10),
wherein the RF frontend (12) comprises at least one port (16) being connectable to a device under test,
wherein the RF frontend (12) comprises at least one measurement path (18) that is connected to the at least one port (16),
wherein the RF frontend (12) comprises a first frontend portion (20) and a second frontend portion (22),
wherein the first frontend portion (20) comprises a first directional unit (28) being connected to the at least one measurement path (18) and being configured to couple an RF signal traveling towards the at least one port (16) out of the at least one measurement path (18), wherein the first frontend portion (20) further comprises a second directional unit (34) being connected to the at least one measurement path (18) and being configured to couple an RF signal traveling away from the at least one port (16) out of the at least one measurement path (18),
**characterized in that**
the second frontend portion (22) comprises a frequency combining unit (42) and a switching stage (40),
wherein the switching stage (40) comprises an input port (44), a common port (46), an output port (48), a first signal path (50), and a second signal path (52),
wherein the switching stage (40) has a first switching state, wherein the switching stage (40) is configured to forward a stimulus RF signal received by the input port (44) to the common port (46) via the first signal path (50) in the first switching state,
wherein the switching stage (40) has a second switching state, wherein the switching stage (40) is configured to forward an RF signal received by the common port (46) to the output port (48) via the second signal path (52) in the second switching state,
wherein the frequency combining unit (42) is connected to the at least one measurement path (18), wherein the frequency combining unit (42) comprises a common port (56) that is connected to the common port (46) of the switching stage (40), wherein the frequency combining unit (42) is configured to couple the stimulus RF signal into the at least one measurement path (18), and wherein the frequency combining unit (42) is configured to couple an RF signal traveling away from the at least one port (16) out of the at least one measurement path (18), such that the RF signal is forwarded to the common port (56) of the frequency combining unit (42), and
wherein the second frontend portion (22) comprises a first amplifier (54) that is arranged within the second signal path (52), wherein the first amplifier (54) is configured to amplify the RF signal received from the measurement path (18) via the frequency combining unit (42), wherein the second frontend portion (22) is configured to obtain an output signal based on the RF signal received from the measurement path (18) via the frequency combining unit (42).

2. The RF frontend of claim 1, wherein the input port (44) of the switching stage (40) is connected or connectable to a signal source that is configured to generate the stimulus RF signal, particularly wherein the signal source is comprised in a VNA base system (14).

3. The RF frontend according to any one of the preceding claims, wherein the output port (48) of the switching stage (40) is connected or connectable to a measurement module (64), particularly wherein the measurement module (64) is comprised in a VNA base system (14).

4. The RF frontend according to any one of the preceding claims, wherein the second frontend portion (22) comprises a stimulus power amplifier (58) being connected to the input port (44) of the switching stage (40) upstream of the input port (44), and/or wherein the second frontend portion (22) comprises an output amplifier (60) being connected to the output port (48) of the switching stage (40) downstream of the output port (48).

5. The RF frontend according to any one of the preceding claims, wherein the second frontend portion (22) comprises a mixing unit (62) that is connected to the output port (48) of the switching stage (40) downstream of the output port (48).

6. The RF frontend according to any one of the preceding claims, wherein the first frontend portion (20) comprises a first pre-amplifier (30) being connected to the first directional unit (28) downstream of the first directional unit (28), and/or a second pre-amplifier (36) being connected to the second directional unit (34) downstream of the second directional unit (34).

7. The RF frontend according to any one of the preceding claims, wherein the first frontend portion (20) comprises a first mixing unit (32) being connected to the first directional unit (28) downstream of the first directional unit (28), and/or a second mixing unit (38) being connected to the second directional unit (34) downstream of the second directional unit (34).

8. The RF frontend according to any one of the preceding claims, wherein the first frontend portion (20) and the second frontend portion (22) are arranged within a common housing.

9. A VNA measurement system, wherein the VNA measurement system (10) comprises an RF frontend (12) according to any one of the preceding claims, wherein the VNA measurement system (10) further comprises a VNA base system (14), wherein the VNA base system (14) comprises a measurement module (64) and a processing module (66), wherein the processing module (66) is configured to control the switching stage (40) to selectively switch between the first switching state and the second switching state.

10. The VNA measurement system of claim 9, wherein the VNA base system (14) is configured to receive a reference signal from the first directional unit (28), wherein the VNA base system (14) further is configured to receive a measurement signal from the second directional unit (34), and wherein the processing module (66) is configured to determine at least one measurement parameter based on the reference signal and based on the measurement signal, particularly wherein the at least one measurement parameter comprises at least one S-parameter.

11. The VNA measurement system of claim 9 or 10, wherein the VNA base system (14) is configured to receive the output signal of the second frontend portion (22), wherein the processing module (66) is configured to determine at least one noise parameter based on the output signal.

12. The VNA measurement system according to any one of claims 9 to 11, wherein the VNA measurement system (10) comprises at least one further RF frontend (82), wherein the at least one further RF frontend (82) comprises a measurement path (18), wherein the measurement path (18) of the RF frontend (12) and the measurement path (18) of the at least one further RF frontend (82) are connected with each other.

13. The VNA measurement system of claim 12, wherein the at least one further RF frontend (82) comprises a first frontend portion (20) and a second frontend portion (22), wherein the VNA measurement system (10) further comprises a measurement switching module (84), wherein the measurement switching module (84) is configured to selectively connect the first frontend portion (20) of the RF frontend (12) or the first frontend portion (20) of the at least one further RF frontend (82) to the VNA base system (14), and/or wherein the measurement switching module (84) is configured to selectively connect the second frontend portion (22) of the RF frontend (12) or the second frontend portion (22) of the at least one further RF frontend (82) to the VNA base system (14).

14. The VNA measurement system of claim 12 or 13, wherein the RF frontend (12) and the at least one further RF frontend (82) are arranged within a common housing.

15. The VNA measurement system according to any one of claims 9 to 14, wherein the VNA measurement system (10) comprises a plurality of ports (16), and wherein the VNA measurement system (10) comprises an RF frontend (12) according to any one of claims 1 to 8 per port (16).

## Patentansprüche

1. Hochfrequenz-Frontend, HF-Frontend, für ein Vektornetzwerkanalysatormesssystem, VNA-Messsystem, (10),
wobei das HF-Frontend (12) mindestens einen Anschluss (16) umfasst, der mit einem Prüfling verbindbar ist,
wobei das HF-Frontend (12) mindestens einen Messpfad (18) umfasst, der mit dem mindestens einen Anschluss (16) verbunden ist,
wobei das HF-Frontend (12) einen ersten Frontend-Abschnitt (20) und einen zweiten Frontend-Abschnitt (22) umfasst,
wobei der erste Frontend-Abschnitt (20) eine erste Richtungseinheit (28) umfasst, die mit dem mindestens einen Messpfad (18) verbunden ist und konfiguriert ist, um ein HF-Signal, das sich zu dem mindestens einen Anschluss (16) hin bewegt, aus dem mindestens einen Messpfad (18) auszukoppeln, wobei der erste Frontend-Abschnitt (20) ferner eine zweite Richtungseinheit (34) umfasst, die mit dem mindestens einen Messpfad (18) verbunden ist und konfiguriert ist, um ein HF-Signal, das sich von dem mindestens einen Anschluss (16) weg bewegt, aus dem mindestens einen Messpfad (18) auszukoppeln,
**dadurch gekennzeichnet, dass** der zweite Frontend-Abschnitt (22) eine Frequenzkombiniereinheit (42) und eine Schaltstufe (40) umfasst,
wobei die Schaltstufe (40) einen Eingangsanschluss (44), einen gemeinsamen Anschluss (46), einen Ausgangsanschluss (48), einen ersten Signalpfad (50) und einen zweiten Signalpfad (52) umfasst,
wobei die Schaltstufe (40) einen ersten Schaltzustand aufweist, wobei die Schaltstufe (40) konfiguriert ist, um ein durch den Eingangsanschluss (44) empfangenes Stimulus-HF-Signal über den ersten Signalpfad (50) in dem ersten Schaltzustand an den gemeinsamen Anschluss (46) weiterzuleiten,
wobei die Schaltstufe (40) einen zweiten Schaltzustand aufweist, wobei die Schaltstufe (40) konfiguriert ist, um ein durch den gemeinsamen Anschluss (46) empfangenes HF-Signal über den zweiten Signalpfad (52) in dem zweiten Schaltzustand an den Ausgangsanschluss (48) weiterzuleiten,
wobei die Frequenzkombiniereinheit (42) mit dem mindestens einen Messpfad (18) verbunden ist, wobei die Frequenzkombiniereinheit (42) einen gemeinsamen Anschluss (56) umfasst, der mit dem gemeinsamen Anschluss (46) der Schaltstufe (40) verbunden ist, wobei die Frequenzkombiniereinheit (42) konfiguriert ist, um das Stimulus-HF-Signal in den mindestens einen Messpfad (18) einzukoppeln, und wobei die Frequenzkombiniereinheit (42) konfiguriert ist, um ein HF-Signal, das sich von dem mindestens einen Anschluss (16) weg bewegt, aus dem mindestens einen Messpfad (18) derart auszukoppeln, dass das HF-Signal an den gemeinsamen Anschluss (56) der Frequenzkombiniereinheit (42) weitergeleitet wird, und
wobei der zweite Frontend-Abschnitt (22) einen ersten Verstärker (54) umfasst, der innerhalb des zweiten Signalpfads (52) angeordnet ist, wobei der erste Verstärker (54) konfiguriert ist, um das HF-Signal zu verstärken, das von dem Messpfad (18) über die Frequenzkombiniereinheit (42) empfangen wird, wobei der zweite Frontend-Abschnitt (22) konfiguriert ist, um ein Ausgangssignal basierend auf dem HF-Signal zu erhalten, das von dem Messpfad (18) über die Frequenzkombiniereinheit (42) empfangen wird.

2. HF-Frontend nach Anspruch 1, wobei der Eingangsanschluss (44) der Schaltstufe (40) mit einer Signalquelle verbunden oder verbindbar ist, die konfiguriert ist, um das Stimulus-HF-Signal zu erzeugen, insbesondere wobei die Signalquelle in einem VNA-Basissystem (14) umfasst ist.

3. HF-Frontend nach einem der vorstehenden Ansprüche, wobei der Ausgangsanschluss (48) der Schaltstufe (40) mit einem Messmodul (64) verbunden oder verbindbar ist, insbesondere wobei das Messmodul (64) in einem VNA-Basissystem (14) umfasst ist.

4. HF-Frontend nach einem der vorstehenden Ansprüche, wobei der zweite Frontend-Abschnitt (22) einen Stimulus-Leistungsverstärker (58) umfasst, der mit dem Eingangsanschluss (44) der Schaltstufe (40) stromaufwärts des Eingangsanschlusses (44) verbunden ist, und/oder wobei der zweite Frontend-Abschnitt (22) einen Ausgangsverstärker (60) umfasst, der mit dem Ausgangsanschluss (48) der Schaltstufe (40) stromabwärts des Ausgangsanschlusses (48) verbunden ist.

5. HF-Frontend nach einem der vorstehenden Ansprüche, wobei der zweite Frontend-Abschnitt (22) eine Mischeinheit (62) umfasst, die mit dem Ausgangsanschluss (48) der Schaltstufe (40) stromabwärts des Ausgangsanschlusses (48) verbunden ist.

6. HF-Frontend nach einem der vorstehenden Ansprüche, wobei der erste Frontend-Abschnitt (20) einen ersten Vorverstärker (30), der mit der ersten Richtungseinheit (28) stromabwärts der ersten Richtungseinheit (28) verbunden ist, und/oder einen zweiten Vorverstärker (36) umfasst, der mit der zweiten Richtungseinheit (34) stromabwärts der zweiten Richtungseinheit (34) verbunden ist.

7. HF-Frontend nach einem der vorstehenden Ansprüche, wobei der erste Frontend-Abschnitt (20) eine erste Mischeinheit (32), die mit der ersten Richtungseinheit (28) stromabwärts der ersten Richtungseinheit (28) verbunden ist, und/oder eine zweite Mischeinheit (38) umfasst, die mit der zweiten Richtungseinheit (34) stromabwärts der zweiten Richtungseinheit (34) verbunden ist.

8. HF-Frontend nach einem der vorstehenden Ansprüche, wobei der erste Frontend-Abschnitt (20) und der zweite Frontend-Abschnitt (22) innerhalb eines gemeinsamen Gehäuses angeordnet sind.

9. VNA-Messsystem, wobei das VNA-Messsystem (10) ein HF-Frontend (12) nach einem der vorstehenden Ansprüche umfasst, wobei das VNA-Messsystem (10) ferner ein VNA-Basissystem (14) umfasst, wobei das VNA-Basissystem (14) ein Messmodul (64) und ein Verarbeitungsmodul (66) umfasst, wobei das Verarbeitungsmodul (66) konfiguriert ist, um die Schaltstufe (40) zu steuern, um selektiv zwischen dem ersten Schaltzustand und dem zweiten Schaltzustand zu schalten.

10. VNA-Messsystem nach Anspruch 9, wobei das VNA-Basissystem (14) konfiguriert ist, um ein Referenzsignal von der ersten Richtungseinheit (28) zu empfangen, wobei das VNA-Basissystem (14) ferner konfiguriert ist, um ein Messsignal von der zweiten Richtungseinheit (34) zu empfangen, und wobei das Verarbeitungsmodul (66) konfiguriert ist, um einen Messparameter basierend auf dem Referenzsignal und basierend auf dem Messsignal zu bestimmen, insbesondere wobei der mindestens eine Messparameter mindestens einen S-Parameter umfasst.

11. VNA-Messsystem nach Anspruch 9 oder 10, wobei das VNA-Basissystem (14) konfiguriert ist, um das Ausgangssignal des zweiten Frontend-Abschnitts (22) zu empfangen, wobei das Verarbeitungsmodul (66) konfiguriert ist, um mindestens einen Rauschparameter basierend auf dem Ausgangssignal zu bestimmen.

12. VNA-Messsystem nach einem der Ansprüche 9 bis 11, wobei das VNA-Messsystem (10) mindestens ein weiteres HF-Frontend (82) umfasst, wobei das mindestens eine weitere HF-Frontend (82) einen Messpfad (18) umfasst, wobei der Messpfad (18) des HF-Frontends (12) und der Messpfad (18) des mindestens einen weiteren HF-Frontends (82) miteinander verbunden sind.

13. VNA-Messsystem nach Anspruch 12, wobei das mindestens eine weitere HF-Frontend (82) einen ersten Frontend-Abschnitt (20) und einen zweiten Frontend-Abschnitt (22) umfasst, wobei das VNA-Messsystem (10) ferner ein Messschaltmodul (84) umfasst, wobei das Messschaltmodul (84) konfiguriert ist, um den ersten Frontend-Abschnitt (20) des HF-Frontends (12) oder den ersten Frontend-Abschnitt (20) des mindestens einen weiteren HF-Frontends (82) selektiv mit dem VNA-Basissystem (14) zu verbinden, und/oder wobei das Messschaltmodul (84) konfiguriert ist, um den zweiten Frontend-Abschnitt (22) des HF-Frontends (12) oder den zweiten Frontend-Abschnitt (22) des mindestens einen weiteren HF-Frontends (82) selektiv mit dem VNA-Basissystem (14) zu verbinden.

14. VNA-Messsystem nach Anspruch 12 oder 13, wobei das HF-Frontend (12) und das mindestens eine weitere HF-Frontend (82) innerhalb eines gemeinsamen Gehäuses angeordnet sind.

15. VNA-Messsystem nach einem der Ansprüche 9 bis 14, wobei das VNA-Messsystem (10) eine Vielzahl von Anschlüssen (16) umfasst, und wobei das VNA-Messsystem (10) ein HF-Frontend (12) nach einem der Ansprüche 1 bis 8 pro Anschluss (16) umfasst.

## Revendications

1. Étage d'entrée radiofréquence, RF, destiné à un système de mesure d'analyseur de réseau vectoriel, VNA (10),
dans lequel l'étage d'entrée RF (12) comprend au moins un port (16) pouvant être connecté à un dispositif en test,
dans lequel l'étage d'entrée RF (12) comprend au moins un trajet de mesure (18) qui est connecté à l'au moins un port (16),
dans lequel l'étage d'entrée RF (12) comprend une première partie d'étage d'entrée (20) et une seconde partie d'étage d'entrée (22),
dans lequel la première partie d'étage d'entrée (20) comprend une première unité directionnelle (28) étant connectée à l'au moins un trajet de mesure (18) et étant configurée pour coupler un signal RF se propageant en direction de l'au moins un port (16) hors de l'au moins un trajet de mesure (18), dans lequel la première partie d'étage d'entrée (20) comprend en outre une seconde unité directionnelle (34) étant connectée à l'au moins un trajet de mesure (18) et étant configurée pour coupler un signal RF se propageant à l'écart de l'au moins un port (16) hors de l'au moins un trajet de mesure (18),
**caractérisé en ce que** la seconde partie d'étage d'entrée (22) comprend une unité de combinaison de fréquence (42) et un étage de commutation (40),
dans lequel l'étage de commutation (40) comprend un port d'entrée (44), un port commun (46), un port de sortie (48), un premier trajet de signal (50) et un second trajet de signal (52),
dans lequel l'étage de commutation (40) a un premier état de commutation, dans lequel l'étage de commutation (40) est configuré pour acheminer un signal RF de stimulation reçu par le port d'entrée (44) vers le port commun (46) par l'intermédiaire du premier trajet de signal (50) dans le premier état de commutation,
dans lequel l'étage de commutation (40) a un second état de commutation, dans lequel l'étage de commutation (40) est configuré pour acheminer un signal RF reçu par le port commun (46) vers le port de sortie (48) par l'intermédiaire du second trajet de signal (52) dans le second état de commutation,
dans lequel l'unité de combinaison de fréquence (42) est connectée à l'au moins un trajet de mesure (18), dans lequel l'unité de combinaison de fréquence (42) comprend un port commun (56) qui est connecté au port commun (46) de l'étage de commutation (40), dans lequel l'unité de combinaison de fréquence (42) est configurée pour coupler le signal RF de stimulation dans l'au moins un trajet de mesure (18), et dans lequel l'unité de combinaison de fréquence (42) est configurée pour coupler un signal RF se propageant à l'écart de l'au moins un port (16) hors de l'au moins un trajet de mesure (18), de telle sorte que le signal RF est acheminé au port commun (56) de l'unité de combinaison de fréquence (42), et
dans lequel la seconde partie d'étage d'entrée (22) comprend un premier amplificateur (54) qui est agencé au sein du second trajet de signal (52), dans lequel le premier amplificateur (54) est configuré pour amplifier le signal RF reçu du trajet de mesure (18) par l'intermédiaire de l'unité de combinaison de fréquence (42), dans lequel la seconde partie d'étage d'entrée (22) est configurée pour obtenir un signal de sortie en fonction du signal RF reçu du trajet de mesure (18) par l'intermédiaire de l'unité de combinaison de fréquence (42).

2. Étage d'entrée RF selon la revendication 1, dans lequel le port d'entrée (44) de l'étage de commutation (40) est connecté ou peut être connecté à une source de signal qui est configurée pour générer le signal RF de stimulation, en particulier dans lequel la source de signal est comprise dans un système de base VNA (14).

3. Étage d'entrée RF selon l'une quelconque des revendications précédentes, dans lequel le port de sortie (48) de l'étage de commutation (40) est connecté ou peut être connecté à un module de mesure (64), en particulier dans lequel le module de mesure (64) est compris dans un système de base VNA (14).

4. Étage d'entrée RF selon l'une quelconque des revendications précédentes, dans lequel la seconde partie d'étage d'entrée (22) comprend un amplificateur de puissance de stimulation (58) étant connecté au port d'entrée (44) de l'étage de commutation (40) en amont du port d'entrée (44), et/ou dans lequel la seconde partie d'étage d'entrée (22) comprend un amplificateur de sortie (60) étant connecté au port de sortie (48) de l'étage de commutation (40) en aval du port de sortie (48).

5. Étage d'entrée RF selon l'une quelconque des revendications précédentes, dans lequel la seconde partie d'étage d'entrée (22) comprend une unité de mélange (62) qui est connectée au port de sortie (48) de l'étage de commutation (40) en aval du port de sortie (48).

6. Étage d'entrée RF selon l'une quelconque des revendications précédentes, dans lequel la première partie d'étage d'entrée (20) comprend un premier préamplificateur (30) étant connecté à la première unité directionnelle (28) en aval de la première unité directionnelle (28), et/ou un second préamplificateur (36) étant connecté à la seconde unité directionnelle (34) en aval de la seconde unité directionnelle (34).

7. Étage d'entrée RF selon l'une quelconque des revendications précédentes, dans lequel la première partie d'étage d'entrée (20) comprend une première unité de mélange (32) étant connectée à la première unité directionnelle (28) en aval de la première unité directionnelle (28), et/ou une seconde unité de mélange (38) étant connectée à la seconde unité directionnelle (34) en aval de la seconde unité directionnelle (34).

8. Étage d'entrée RF selon l'une quelconque des revendications précédentes, dans lequel la première partie d'étage d'entrée (20) et la seconde partie d'étage d'entrée (22) sont agencées au sein d'un logement commun.

9. Système de mesure VNA, dans lequel le système de mesure VNA (10) comprend un étage d'entrée RF (12) selon l'une quelconque des revendications précédentes, dans lequel le système de mesure VNA (10) comprend en outre un système de base VNA (14), dans lequel le système de base VNA (14) comprend un module de mesure (64) et un module de traitement (66), dans lequel le module de traitement (66) est configuré pour commander l'étage de commutation (40) pour commuter sélectivement entre le premier état de commutation et le second état de commutation.

10. Système de mesure VNA selon la revendication 9, dans lequel le système de base VNA (14) est configuré pour recevoir un signal de référence en provenance de la première unité directionnelle (28), dans lequel le système de base VNA (14) est configuré en outre pour recevoir un signal de mesure en provenance de la seconde unité directionnelle (34), et dans lequel le module de traitement (66) est configuré pour déterminer au moins un paramètre de mesure en fonction du signal de référence et en fonction du signal de mesure, en particulier dans lequel l'au moins un paramètre de mesure comprend au moins un paramètre S.

11. Système de mesure VNA selon la revendication 9 ou 10, dans lequel le système de base VNA (14) est configuré pour recevoir le signal de sortie de la seconde partie d'étage d'entrée (22), dans lequel le module de traitement (66) est configuré pour déterminer au moins un paramètre de bruit en fonction du signal de sortie.

12. Système de mesure VNA selon l'une quelconque des revendications 9 à 11, dans lequel le système de mesure VNA (10) comprend au moins un étage d'entrée RF supplémentaire (82), dans lequel l'au moins un étage d'entrée RF supplémentaire (82) comprend un trajet de mesure (18), dans lequel le trajet de mesure (18) de l'étage d'entrée RF (12) et le trajet de mesure (18) de l'au moins un étage d'entrée RF supplémentaire (82) sont connectés l'un à l'autre.

13. Système de mesure VNA selon la revendication 12, dans lequel l'au moins un étage d'entrée RF supplémentaire (82) comprend une première partie d'étage d'entrée (20) et une seconde partie d'étage d'entrée (22), dans lequel le système de mesure VNA (10) comprend en outre un module de commutation de mesure (84), dans lequel le module de commutation de mesure (84) est configuré pour connecter sélectivement la première partie d'étage d'entrée (20) de l'étage d'entrée RF (12) ou la première partie d'étage d'entrée (20) de l'au moins un étage d'entrée RF supplémentaire (82) au système de base VNA (14), et/ou dans lequel le module de commutation de mesure (84) est configuré pour connecter sélectivement la seconde partie d'étage d'entrée (22) de l'étage d'entrée RF (12) ou la seconde partie d'étage d'entrée (22) de l'au moins un étage d'entrée RF supplémentaire (82) au système de base VNA (14).

14. Système de mesure VNA selon la revendication 12 ou 13, dans lequel l'étage d'entrée RF (12) et l'au moins un étage d'entrée RF supplémentaire (82) sont agencés au sein d'un logement commun.

15. Système de mesure VNA selon l'une quelconque des revendications 9 à 14, dans lequel le système de mesure VNA (10) comprend une pluralité de ports (16), et dans lequel le système de mesure VNA (10) comprend un étage d'entrée RF (12) selon l'une quelconque des revendications 1 à 8 par port (16).
